(19) Europäisches Patentamt
European Patent Office
Office européen des brevets

(11) **EP 1 367 723 B1**

(12) **FASCICULE DE BREVET EUROPEEN**

(45) Date de publication et mention
de la délivrance du brevet:
**09.08.2006 Bulletin 2006/32**

(51) Int Cl.:
***H03M 7/32*** *(2006.01)*    ***H03M 7/36*** *(2006.01)*

(21) Numéro de dépôt: **03291288.3**

(22) Date de dépôt: **28.05.2003**

(54) **Modulateur sigma-delta numérique-numérique et synthetiseur de fréquence numérique l'incorporant**

Digitaler Sigma-Delta Modulator und Digitaler Frequenzsynthetisierer mit einem solchen Modulator

Digital sigma-delta-modulator, and digital frequency synthesiser comprising the same

(84) Etats contractants désignés:
**DE FR GB IT**

(30) Priorité: **28.05.2002 FR 0206500**

(43) Date de publication de la demande:
**03.12.2003 Bulletin 2003/49**

(73) Titulaire: **STMicroelectronics S.A.**
**92120 Montrouge (FR)**

(72) Inventeurs:
• **Level, Philippe**
**38120 Saint-Egreve (FR)**
• **Ramet, Serge**
**38100 Grenoble (FR)**
• **Camino, Laurent**
**38000 Grenoble (FR)**

(74) Mandataire: **Verdure, Stéphane**
**Cabinet Plasseraud**
**65/67 rue de la Victoire**
**75440 Paris Cedex 09 (FR)**

(56) Documents cités:
**US-B1- 6 344 812**

• **PATENT ABSTRACTS OF JAPAN vol. 1997, no. 02, 28 février 1997 (1997-02-28) & JP 08 256061 A (MATSUSHITA ELECTRIC IND CO LTD), 1 octobre 1996 (1996-10-01)**
• **HARRIS F: "A MODIFIED DELTA-SIGMA QUANTIZER TO OBTAIN HIGH RESOLUTION A/D CONVERSION WITH SMALL EXCESS SAMPLE RATES" PROCEEDINGS OF THE ASILOMAR CONFERENCE ON SIGNALS, SYSTEMS AND COMPUTERS. PACIFIC GROVE, OCT. 31 - NOV. 2, 1988. TWO VOLUMES BOUND AS ONE, NEW YORK, IEEE, US, vol. VOLS. 1 & 2 CONF. 22, 31 octobre 1988 (1988-10-31), pages 622-625, XP000130325**
• **MAGRATH A J ET AL: "A sigma-delta modulator topology with high linearity" CIRCUITS AND SYSTEMS, 1997. ISCAS '97., PROCEEDINGS OF 1997 IEEE INTERNATIONAL SYMPOSIUM ON HONG KONG 9-12 JUNE 1997, NEW YORK, NY, USA,IEEE, US, 9 juin 1997 (1997-06-09), pages 53-56, XP010235973 ISBN: 0-7803-3583-X**

**Description**

La présente invention se rapporte au domaine des modulateurs Sigma-Delta (modulateur $\Sigma$-$\Delta$) numérique-numérique. Elle trouve des applications, en particulier, dans les synthétiseurs de fréquence numériques ou circuits DMS (de anglais "Digitally Modulated Synthetizer",). De tels circuits sont utilisés, notamment, dans les émetteurs radiofréquences des terminaux mobiles ou des stations fixes d'un système de radiocommunications.

Un modulateur $\Sigma$-$\Delta$ numérique-numérique est un dispositif d'encodage d'un signal numérique utilisant un petit nombre de pas, et une fréquence d'échantillonnage élevée par rapport à la bande passante du signal à encoder. Ce dispositif met en forme le spectre du bruit de quantification en repoussant sa puissance dans une bande de fréquence non occupée par le spectre du signal utile. Cette séparation spectrale permet, grâce à un filtrage du signal encodé, de conserver un rapport signal à bruit conforme à des spécifications données.

Un modulateur Sigma-Delta numérique-numérique comprend :

- une entrée pour recevoir une valeur numérique d'entrée codée sur N bits, où N est un nombre entier déterminé ;

- une sortie pour délivrer une valeur numérique de sortie codée sur n bits, où n est un nombre entier déterminé inférieur à N ; et,

- une ou plusieurs cellules Sigma-Delta disposées entre l'entrée et la sortie du modulateur.

Chaque cellule peut être du premier ordre ou d'un ordre supérieur. Lorsque le modulateur comprend plusieurs cellules, celles-ci peuvent être agencées selon une structure connue de l'Homme du métier sous le nom de "structure MASH". Dans ce cas, les cellules sont souvent identiques entre elles, mais ceci n'est pas obligatoire. Notamment, certaines peuvent être du premier ordre, et d'autres d'un ordre supérieur.

Dans tous les cas, chaque cellule Sigma-Delta comprend au minimum les éléments suivants :

- un soustracteur comprenant une première entrée, une seconde entrée, et une sortie, la première entrée étant couplée à l'entrée du modulateur pour recevoir la valeur numérique d'entrée ou une valeur dérivée de celle-ci ;

- un intégrateur comprenant une entrée couplée à la sortie du soustracteur, et une sortie ; et,

- un quantificateur ayant une entrée couplée à la sortie de l'intégrateur et une sortie couplée à la seconde entrée du soustracteur. La sortie du quantificateur est, en outre, couplée à la sortie du modulateur pour délivrer la valeur numérique de sortie ou une contribution à celle-ci. Le quantificateur possède un échelon de quantification déterminé.

En pratique, l'entrée du modulateur reçoit des valeurs successives d'un signal numérique d'entrée, occupant une bande passante très inférieure à la fréquence d'échantillonnage. Les valeurs de sortie correspondantes forment un signal de sortie, qui est un signal numérique.

Un problème particulièrement gênant pour la mise en oeuvre d'un tel modulateur réside dans l'apparition imprévisible (sauf simulations exhaustives, parfois irréalisables en pratique) de cycles limites. Ces cycles limites dépendent de la valeur du signal d'entrée, de l'architecture du modulateur $\Sigma$-$\Delta$ et des conditions initiales. Ils se manifestent par la concentration d'une partie importante de la puissance du signal de sortie dans un petit nombre de raies (raies de puissance plus élevée que la moyenne locale). Ces situations altèrent la performance de codage recherchée en augmentant la puissance du bruit de codage dans la bande passante du signal utile.

L'analyse du comportement d'un modulateur $\Sigma$-$\Delta$ numérique-numérique entre dans le cadre de l'étude des systèmes dits "machines de Mealy séquentielles" et des asservissements non linéaires. L'analyse "harmonique" d'un modulateur $\Sigma$-$\Delta$ numérique-numérique permet de prévoir sa fonction de transfert et ses performances de codage en faisant l'hypothèse que le quantificateur introduit une erreur de codage dont le spectre est celui d'un bruit blanc decorrélé du signal d'entrée. Avec cette hypothèse, on obtient une prévision du comportement du modulateur $\Sigma$-$\Delta$ conforme à la simulation, sauf lors de l'apparition de cycles limites.

Aucun dispositif ayant les propriétés de codage d'un modulateur $\Sigma$-$\Delta$ numérique-numérique sans les inconvénients de l'existence de cycles limites imprévisibles n'a pu être décrit.

Un objet de l'invention est de permettre de diminuer l'occurrence et la puissance des cycles limites d'un modulateur $\Sigma$-$\Delta$ numérique-numérique.

Un premier aspect de l'invention concerne un modulateur du type précité, dans lequel l'échelon de quantification du quantificateur est un nombre premier.

Ainsi qu'il apparaîtra plus clairement à la lecture de la description qui va suivre, cette caractéristique permet d'allonger au maximum la durée des cycles du signal de sortie. Il s'ensuit que l'énergie de ce signal étant répartie dans un plus grand nombre de raies, celles-ci sont de plus faible puissance. Les mécanismes conduisant à l'apparition de cycles limites produisent ceux-ci avec une puissance diminuée (ce phénomène a été observé en simulation).

Un second aspect de l'invention concerne un synthétiseur de fréquence numérique comprenant une boucle à verrouillage de phase ayant un diviseur de fréquence variable dans le chemin de rétroaction, et comprenant en outre un modulateur ∑-Δ numérique-numérique selon le premier aspect, pour encoder un signal de commande du rapport de division dudit diviseur de fréquence variable.

La description qui suit doit être lue en regard des dessins annexés sur lesquels :

-   la figure 1 est un schéma d'un modulateur ∑-Δ numérique-numérique à une cellule du premier ordre ;
-   la figure 2 est un graphe montrant la caractéristique d'un quantificateur à deux niveaux de sortie ;
-   les figures 3a à 3d sont des graphes montrant l'évolution en fonction du temps du signal I en entrée du quantificateur et du signal de sortie Y d'un modulateur selon la figure 1, respectivement pour quatre couples déterminés de valeurs du signal d'entrée X du modulateur et de l'échelon de quantification q du quantificateur ;
-   les figures 4a à 4d sont des graphes montrant le spectre du signal de sortie Y d'un modulateur selon la figure 1, pour chacun des couples des valeurs du signal d'entrée X du modulateur et de l'échelon de quantification q du quantificateur des figures 3a à 3d, respectivement;
-   la figure 5 est un graphe montrant la caractéristique d'un quantificateur à $(2 \times K)$ +1 niveaux de sortie, où K est un nombre entier ;
-   la figure 6 est un schéma illustrant un modulateur ∑-Δ numérique-numérique ayant trois cellules du premier ordre agencées selon une structure MASH ;
-   les figures 7a à 7d sont des graphes montrant le spectre du signal de sortie Y d'un modulateur selon la figure 6, chacun pour un couple déterminé de valeurs du signal d'entrée X du modulateur et de l'échelon de quantification q du quantificateur ; et,
-   la figure 8 est un schéma illustrant un synthétiseur de fréquence numérique incorporant un modulateur ∑-Δ numérique-numérique selon l'invention.

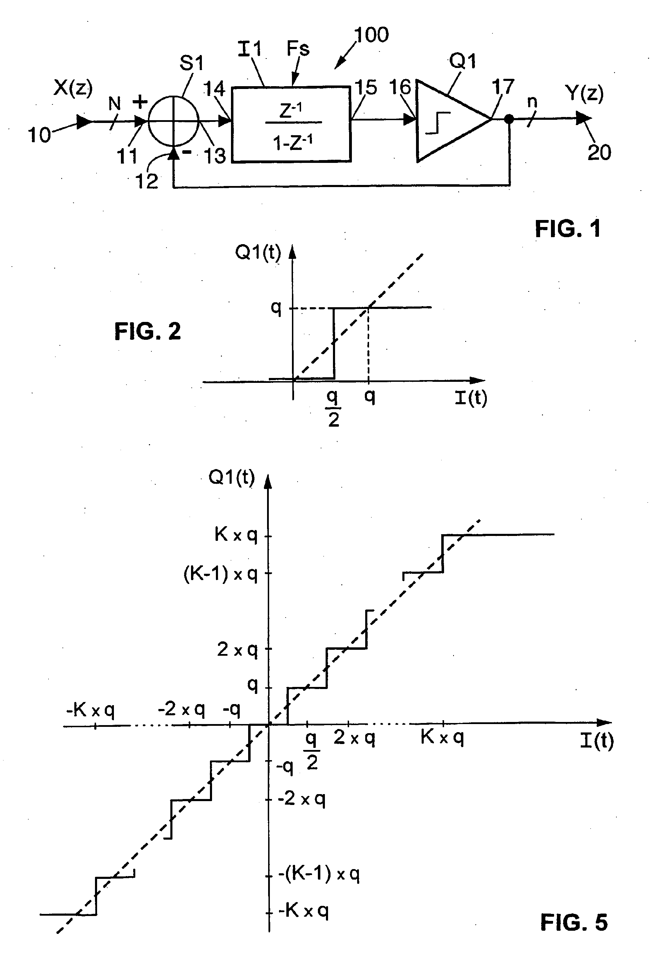

Pour illustrer l'effet produit par l'invention, on peut considérer le cas d'un modulateur ∑-Δ numérique-numérique tel que le modulateur représenté schématiquement à la figure 1. Un tel modulateur est le plus simple possible, puisqu'il ne comprend qu'une seule cellule ∑-Δ, et que cette cellule est du premier ordre.

Le modulateur comprend une entrée 10 pour recevoir les valeurs numériques successives, chacune codée sur N bits, où N est un nombre entier déterminé, d'un signal numérique d'entrée X. Dans la suite, la lettre X désigne aussi bien le signal d'entrée du modulateur qu'une valeur déterminée de ce signal.

Le modulateur comprend aussi une sortie 20 pour délivrer les valeurs numériques successives, chacune codée sur n bits, où n est un nombre entier déterminé inférieur à N, d'un signal numérique de sortie Y. Dans la suite, la lettre Y désigne aussi bien le signal de sortie du modulateur qu'une valeur déterminée de ce signal.

Le signal Y correspond au signal X encodé grâce au modulateur. Le signal Y étant codé sur un nombre de bits plus petit que le nombre de bits servant à coder le signal X, une erreur de codage est introduite. La structure du modulateur ∑-Δ numérique-numérique permet de mettre en forme ce bruit de codage (ou bruit de quantification).

Le modulateur de la figure 1 comprend une unique cellule ∑-Δ, notée 100. La cellule 100 est ici du premier ordre. Elle comprend les éléments suivants :

-   un soustracteur S1 comprenant une première entrée 11, une seconde entrée 12, et une sortie 13. L'entrée 11 est couplée à l'entrée 10 du modulateur pour recevoir la valeur numérique d'entrée X ;
-   un intégrateur 11 comprenant une entrée 14 et une sortie 15. L'entrée 14 est couplée à la sortie 13 du soustracteur S1. La sortie 15 délivre un signal codé sur n bits. L'intégrateur est un intégrateur numérique. De façon connue, un tel intégrateur peut être réalisé sous la forme d'un registre accumulateur cadencé à une fréquence d'échantillonnage déterminée Fs ; et,
-   un quantificateur Q1 ayant une entrée 16 et une sortie 17. L'entrée 16 est couplée à la sortie 15 de l'intégrateur 11 pour recevoir le signal I délivré par celle-ci. La sortie 17 est couplée à la seconde entrée 12 du soustracteur S1. En outre, la sortie 17 est couplée à la sortie 20 du modulateur pour délivrer les valeurs numériques du signal de sortie Y à la fréquence d'échantillonnage Fs. Le quantificateur Q1 a un échelon de quantification déterminé, noté q dans la suite et aux figures.

La sortie I(t) de l'intégrateur I1 du modulateur du premier ordre est exprimée, à l'instant $t=n \times Ts$, où Ts désigne la période d'échantillonnage (Ts=1/Fs), par la relation suivante :

$$I(n \times Ts) = I((n-1) \times Ts) + (X((n-1) \times Ts) - Y((n-1) \times Ts)) \qquad (1)$$

La valeur de sortie Y(t) du modulateur est, pour un quantificateur à deux niveaux de sortie par exemple, égale à q1 si $I(t) \geq \dfrac{q}{2}$ ou égale à 0 dans le cas contraire. La caractéristique d'un tel quantificateur à deux niveaux de sortie est illustrée par le graphe de la figure 2. Le signal Y en sortie du modulateur est alors codé sur un bit unique (n=1).

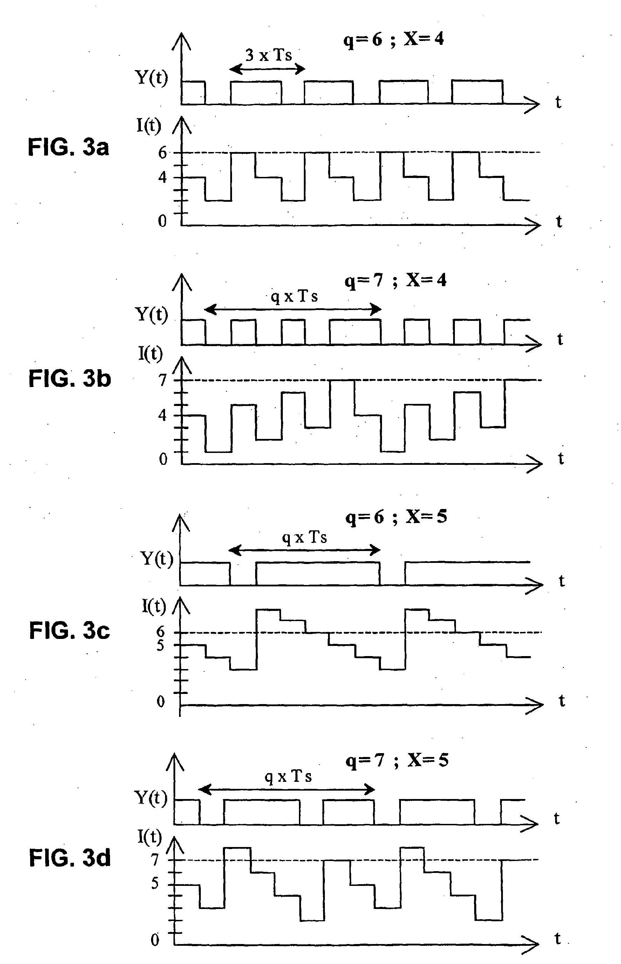

Les graphes des figures 3a à 3d montrent l'évolution en fonction du temps du signal I en entrée du quantificateur Q1 (graphe du bas) et du signal de sortie Y (graphe du haut) d'un modulateur selon la figure 1, respectivement pour quatre couples déterminés de l'échelon de quantification q du quantificateur Q1 et de la valeur du signal d'entrée X :

- à la figure 3a, q est égal à 6 et X est égal à 4 (q1=6 ; X=4) ;
- à la figure 3b, q est égal à 7 et X est égal à 4 (q1=7 ; X=4) ;
- à la figure 3c, q est égal à 6 et X est égal à 5 (q1=6 ; X=5) ; et,
- à la figure 3d, q est égal à 7 et X est égal à 5 (q1=7 ; X=5).

La valeur I(t) change à chaque période Ts. Ainsi qu'on peut le voir, la valeur de Y évolue aussi dans le temps, en étant périodique. On note T la période du signal Y(t). Cette période correspond à la durée maximum d'un cycle de l'accumulateur. La durée T est représentée sur le graphe du haut par une flèche horizontale. C'est en quelque sorte la valeur moyenne du signal Y(t) sur une période T qui détermine la valeur d'entrée X encodée.

Pour une même valeur de X, la durée T peut varier selon la valeur de q. De même, pour une même valeur de q, la durée T peut varier selon la valeur de X. On peut montrer que la période T est définie par la relation suivante :

$$T = \frac{q}{D} \times Ts \qquad (2)$$

où D est le plus grand dénominateur commun (PGDC) entre X et q c'est-à-dire que D=PGDC(X,q).

Ainsi, la durée T d'un cycle est maximalé lorsque les valeurs X et q1 sont premières entre elles.

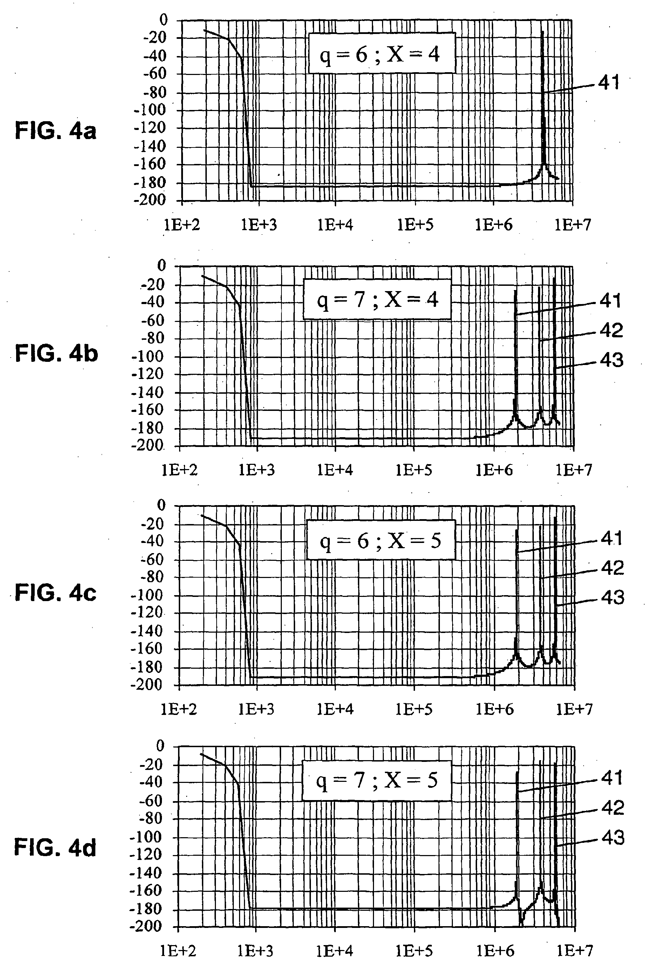

Les figures 4a à 4d représentent le spectre du bruit de quantification pour les quatre exemples correspondant aux figures 3a à 3d, respectivement, avec Fs=13 MHz (mégahertz). Il s'agit d'un spectre de raies dans la bande de fréquence proche de la fréquence d'échantillonnage Fs.

Ainsi qu'on peut le voir, le spectre du bruit comporte à chaque fois une raie 41 à environ -12 dB (décibels), à une fréquence F déterminée, telle que $F = \dfrac{1}{T} = \dfrac{D}{q} \times Fs$. Dans le cas de la figure 4a, cette raie 41 est située à la fréquence F = Fs/3, car D est égal à 2. Dans le cas des figures 4b, 4c et 4d, cette raie 41 est située à $\dfrac{Fs}{q}$ car D est égal à l'unité. Surtout, dans le cas des figures 4b, 4c et 4d, le spectre comprend d'autres raies 42 et 43. Il s'ensuit que l'énergie du bruit de quantification est répartie entre plusieurs raies, et est donc plus facile à éliminer par filtrage.

On constate donc que si q et X sont des valeurs premières entre elles, l'énergie de quantification est répartie dans un plus grand nombre de raies (figures 4b, 4c et 4d) que dans le cas contraire (figure 4a).

Comme on ne peut faire aucune hypothèse à priori sur les valeurs du signal d'entrée X à coder, l'invention propose de donner à l'échelon de quantification q la valeur d'un nombre premier. Les valeurs q et X seront donc toujours premières entre elles. Leur PGDC est donc toujours égal à l'unité, en sorte que la durée T sera toujours maximale. Ceci se traduit pour un modulateur Σ-Δ d'ordre 1 par un spectre du signal de sortie qui est indépendant du code d'entrée, avec un niveau des raies minimal. Dans le cas d'un modulateur Σ-Δ d'ordre plus élevé, les cycles limites (apparaissant pour certains codes d'entrée) ne sont pas supprimés mais ils sont atténués.

Bien entendu, l'invention ne se limite pas au cas d'un quantificateur ayant deux niveaux de sorties seulement.

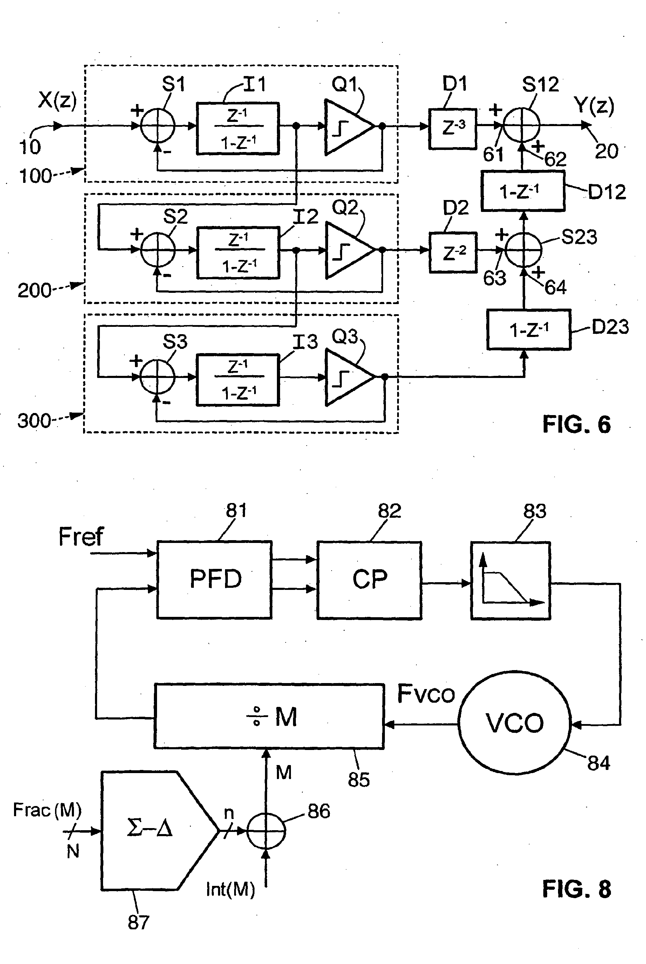

Le graphe de la figure 5 illustre un exemple de caractéristique du quantificateur lorsque ce dernier a (2xK)+1 niveaux de sorties différents. Dans cet exemple, la quantification est dite uniforme car l'échelon de quantification q1 a une valeur constante quelle que soit la valeur du signal I(t). Cette caractéristique est en marches d'escalier, et représente le cas d'une quantification appelée "arrondi". En effet, toute valeur du signal I(t) comprise entre $\left(j - \dfrac{1}{2}\right) \times q$ et

$\left(j + \dfrac{1}{2}\right) \times q$ est arrondie à j×q, lorsque j est compris entre -K et K, où K est un nombre entier déterminé.

On peut noter que, dans le cas d'un quantificateur ayant ainsi (2 x K) + 1 niveaux de sorties, le nombre D précité est égal au plus grand diviseur commun de la valeur X et de la valeur $2 \times K \times q$, c'est-à-dire égal à PGDC (X, 2 x K x q) .

Bien entendu, l'invention ne se limite pas non plus au cas d'un modulateur Σ-Δ numérique-numérique du premier ordre. La cellule 100 du modulateur peut être du second ordre ou plus. En outre, le modulateur peut comprendre P-1 autres cellules Sigma-Delta, où P est un nombre entier supérieur ou égal à 2. Dans ce cas, les P cellules Sigma-Delta sont préférentiellement agencées selon une structure MASH. On obtient ainsi un modulateur d'ordre P, lorsque chaque cellule est du premier ordre. Plus généralement l'ordre du modulateur est alors la somme des ordres respectifs des cellules Sigma-Delta du modulateur.

Un exemple de modulateur de ce type, comprenant trois cellules 100, 200 et 300, c'est-à-dire dans le cas où P est égal à trois (P=3); est représenté schématiquement à la figure 6. Sur cette figure, les mêmes éléments qu'à la figure 1 portent les mêmes références. En plus de la cellule 100, le modulateur comprend ici deux cellules supplémentaires 200 et 300.

De préférence, les trois cellules ont des structures identiques. Cela simplifie la réalisation sur silicium. Dans cet exemple, elles sont du premier ordre, c'est-à-dire qu'elles sont de même structure que la cellule 100 du modulateur représenté à la figure 1 et décrite plus haut. Par structure d'une cellule, on entend ici l'architecture générale de la cellule c'est-à-dire la nature, le nombre et l'agencement des éléments qui la composent. Ces éléments ont été décrits plus haut en ce qui concerne la cellule 100 représentée à la figure 1.

Par commodité, on note S1, S2 et S3 les soustracteurs respectifs des cellules respectivement 100, 200 et 300. De même, on note I1, I2 et I3 les intégrateurs respectifs des cellules respectivement 100, 200 et 300. Enfin, on note Q1, Q2 et Q3 les quantificateurs respectifs des cellules respectivement 100, 200 et 300.

La première entrée du soustracteur S1 de la cellule 100 est couplée à l'entrée 10 du modulateur. La sortie du quantificateur Q1 est couplée à une première entrée 61 d'un additionneur S12 à travers un retardateur D1. La sortie de l'additionneur S12 est couplée à la sortie 20 du modulateur pour délivrer le signal Y.

La première entrée du soustracteur S2 de la cellule 200 est couplée à la sortie de l'intégrateur I1 de la cellule 100. La sortie du quantificateur Q2 est couplée à une première entrée 63 d'un autre additionneur S23 à travers un autre retardateur D2. La sortie de l'additionneur S23 est couplée à une seconde entrée 62 de l'additionneur S12 à travers un autre retardateur D12.

La première entrée du soustracteur S3 de la cellule 300 est couplée à la sortie de l'intégrateur 12 de la cellule 200. La sortie du quantificateur Q3 est couplée à une seconde entrée 64 de l'additionneur S23 à travers un autre retardateur D23.

Dit autrement, la première entrée du soustracteur S2 de la deuxième cellule 200 reçoit un signal dérivé du signal d'entrée X. Plus spécifiquement, elle est couplée à l'entrée 10 pour recevoir le signal X à travers le soustracteur I1 et l'intégrateur I1 de la première cellule 100. De même, la première entrée du soustracteur S3 de la troisième cellule 200 reçoit un signal dérivé du signal d'entrée X. Plus spécifiquement, elle est couplée à l'entrée 10 pour recevoir le signal X à travers le soustracteur S1 et l'intégrateur I1 de la première cellule 100, et en outre à travers le soustracteur S2 et l'intégrateur I2 de la deuxième cellule 100.

Le retardateur D1 introduit un retard correspondant à trois périodes Ts. De même, le retardateur D2 introduit un retard correspondant à deux périodes Ts.

Le signal de sortie Y résulte de la contribution additive des signaux délivrés par les quantificateurs Q1, Q2 et Q3 des cellules respectivement 100, 200 et 300.

Une structure MASH telle que décrite ci-dessus est connue de l'Homme du métier, et son fonctionnement n'appelle pas de commentaire particulier.

Selon l'invention, les échelons de quantification respectifs des quantificateurs Q1, Q2 et Q3, respectivement de chacune des cellules 100, 200 et 300, sont tous égaux à un même nombre premier noté q.

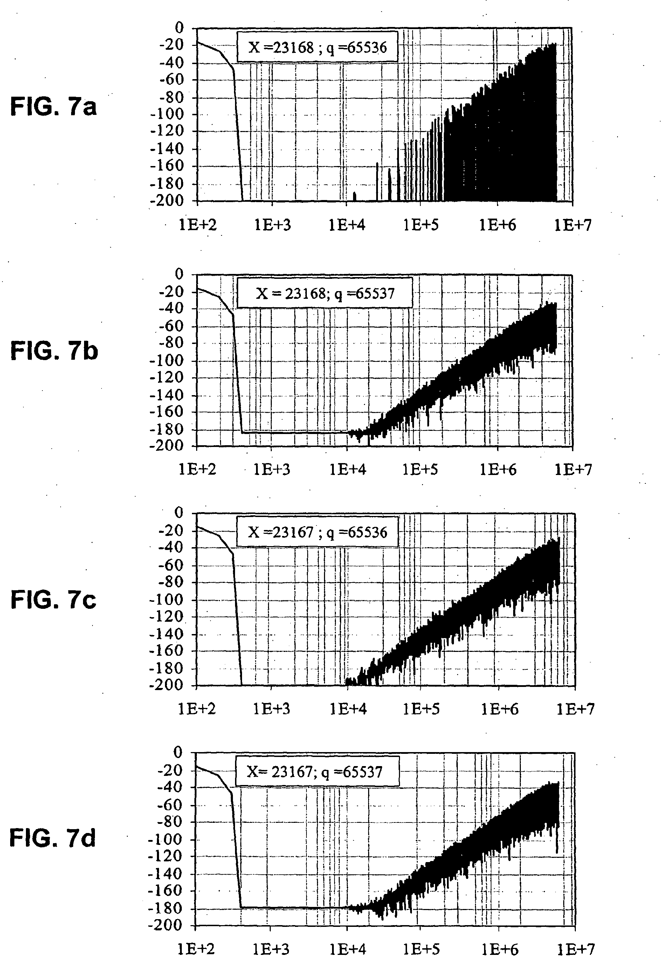

Aux figures 7a à 7d, on a représenté des graphes montrant le spectre du signal de sortie Y d'un modulateur selon la figure 6, chacun pour un couple déterminé de valeurs du signal d'entrée X du modulateur et de l'échelon de quantification q du quantificateur de chacune des cellules Σ-Δ, avec un quantificateur à trois niveaux de sortie (-q, 0 et q) et avec Fs=13 Mhz :

- à la figure 7a, q est égal à 65536 et X est égal à 23168 ;
- à la figure 7b, q est égal à 65537 et X est égal à 23168 ;

- à la figure 7c, q est égal à 65536 et X est égal à 23167 ; et,
- à la figure 7d, q est égal à 65537 et X est égal à 23167.

Les nombres 65537 et 23167 sont des nombres premiers. Comme on peut le voir, l'énergie du bruit de quantification (bruit à hautes fréquences) est répartie sur bien plus de raies sur les graphes des figures 7b, 7c et 7d que sur celui de la figure 7a. Le niveau de ces raies est d'ailleurs visiblement plus faible que dans le cas de la figure 7a, et ce quelles que soient les fréquences que l'on considère entre 10 kHz (kilohertz) et 1,5 MHz.

La figure 8 illustre de façon schématique un synthétiseur de fréquence numérique incorporant un modulateur $\Sigma$-$\Delta$ numérique-numérique selon le premier aspect de l'invention.

Le synthétiseur comprend une boucle à verrouillage de phase ou PLL (de l'anglais "Phase Locked Loop") à pompe de charge. La PLL comprend les éléments suivants en boucle :

- un détecteur de phase et fréquence 81 (ou PFD, de l'anglais "Phase Frequency Detector") ;
- une pompe de charge 82 (ou CP, de l'anglais "Charge Pump") ;
- un filtre de boucle 83, qui est un filtre passe-bas (intégrateur) ;
- un oscillateur commandé en tension 84 (ou VCO, de l'anglais "Voltage Controlled Oscillator") ;
- un diviseur de fréquence variable 85, dont le rapport variable est noté M à la figure et dans la suite.

Le détecteur de phase 81 détecte la différence de phase entre une fréquence de référence Fref et la fréquence Fvco du signal de sortie du VCO divisée par le rapport M du diviseur de fréquence 85. Il applique des impulsions de charge et de décharge (en anglais: "charge-up/charge-down pulses"), respectivement U et D à la pompe de charge 82. Ces impulsions sont utilisées pour commuter des sources de tension ou de courant, qui chargent ou déchargent un condensateur. Ces impulsions sont utilisées pour commuter des sources de courant qui chargent ou déchargent un condensateur du filtre de boucle 83. Le filtre de boucle filtre ces impulsions et délivre une tension de commande résultante au VCO. La fréquence d'oscillation Fvco du VCO est modifiée en fonction de cette tension de commande. Ainsi, la PLL forme un système bouclé dans lequel la fréquence Fvco du signal en sortie du VCO est verrouillée sur la fréquence Fref x M. La sortie du système est la sortie du VCO. Le diviseur de fréquence est compris dans le chemin de rétroaction. Il comprend une entrée de commande du rapport de division M, qui reçoit un signal de commande (également noté M par commodité) permettant de changer la valeur de la fréquence Fvco du signal de sortie de la PLL.

Ainsi qu'il est connu en soi, le signal de commande du rapport de division M du diviseur de fréquence 85 est généré par un modulateur $\Sigma$-$\Delta$ numérique-numérique.

Dans l'exemple représenté, le rapport M comprend une partie entière Int(M) et une partie fractionnaire Frac(M) qui sont ajoutées dans un additionneur 86. La sortie de l'additionneur 86 délivre le signal de commande M. Le synthétiseur comprend un modulateur $\Sigma$-$\Delta$ numérique-numérique 87 selon le premier aspect de l'invention, par exemple du type décrit à la figure 1 ou à la figure 6, pour encoder la partie fractionnaire Frac(M) du signal M avant qu'elle soit ajoutée à la partie entière Int(M) de ce signal.

Dit autrement, le modulateur 87 reçoit en entrée le signal Frac(M) codé sur N bits, et délivre en sortie un signal correspondant codé sur n bits, avec n inférieur à N, qui est ajouté au signal Int(M) dans l'additionneur 86 pour former le signal de commande du rapport de division M du diviseur de fréquence 85 de la PLL. Les raies parasites du signal sur n bits en sortie du modulateur $\Sigma$-$\Delta$ sont éliminées par le filtrage passe-bas de la PLL.

Dans certaines applications, le signal Int(M) peut déterminer la fréquence d'un canal et le signal Frac(M) peut être un signal de modulation de phase ou fréquence. Ceci n'est qu'un exemple d'application. On conçoit que l'invention est utile dans ce genre d'application, puisqu'elle permet de préserver la pureté spectrale du signal de sortie du VCO. Ceci est avantageux, en particulier, dans les applications du synthétiseur à un émetteur radiofréquence.

## Revendications

1. Modulateur Sigma-Delta numérique-numérique (1) comprenant :

   - une entrée (10) pour recevoir une valeur numérique d'entrée (X) codée sur N bits, où N est un nombre entier déterminé ;
   - une sortie (20) pour délivrer une valeur numérique de sortie (Y) codée sur n bits, où n est un nombre entier déterminé inférieur à N ; et,
   - au moins une première cellule Sigma-Delta (100) qui comprend :
   - un soustracteur (S1) comprenant une première entrée (11), une seconde entrée (12), et une sortie (13), la première entrée (11) étant couplée à l'entrée (10) ;
   - un intégrateur (11) comprenant une entrée (14) couplée à la sortie (13) du soustracteur (S1), et une sortie (15) ; et,

- un quantificateur (Q1) ayant une entrée (16) couplée à la sortie (15) de l'intégrateur (11) et une sortie (17) couplée à la sortie (20) et couplée en outre à la seconde entrée (12) du soustracteur (S1), le quantificateur ayant un échelon de quantification (q1) déterminé,

**caractérisé en ce que** l'échelon de quantification (q1) du quantificateur (Q1) est un nombre premier.

2. Modulateur selon la revendication 1, **caractérisé en ce qu'**il comprend en outre P-1 autres cellules Sigma-Delta (200,300), où P est un nombre entier supérieur ou égal à 2, les P cellules (100,200,300) étant agencées selon une structure MASH, et **en ce que** l'échelon de quantification du quantificateur de chacune desdites P cellules est égal audit nombre premier.

3. Modulateur selon la revendication 2, **caractérisé en ce que** les P-1 autres cellules (200,300) sont de même structure que la première cellule (100).

4. Modulateur selon la revendication 2 ou la revendication 3, **caractérisé en ce que** les P cellules (100,200,300) sont des cellules du premier ordre.

5. Modulateur selon l'une quelconque des revendications 2 à 4, **caractérisé en ce que** les échelons de quantification respectifs des quantificateurs (Q1,Q2,Q3), respectivement de chacune des P cellules (100,200,300), sont égaux entre eux.

6. Synthétiseur de fréquence numérique (figure 8) comprenant une boucle à verrouillage de phase ayant un diviseur de fréquence variable dans le chemin de rétroaction, **caractérisé en ce qu'**il comprend en outre un modulateur $\Sigma$-$\Delta$ numérique-numérique selon l'une quelconque des revendications 1 à 5 (87) pour encoder un signal de commande du rapport de division (Frac(M)) dudit diviseur de fréquence variable.

## Claims

1. Digital to digital Sigma-Delta modulator (1) comprising:

- an input (10) for receiving a digital input value (X) encoded over N bits, where N is a specified integer;
- an output (20) for delivering a digital output value (Y) encoded over n bits, where n is a specified integer less than N; and
- at least one first Sigma-Delta cell (100) which comprises:

- a subtractor (S1) comprising a first input (11), a second input (12), and an output (13), the first input (11) being coupled to the input (10);
- an integrator (I1) comprising an input (14) coupled to the output (13) of the subtractor (S1), and an output (15); and
- a quantizer (Q1) having an input (16) coupled to the output (15) of the integrator (I1) and an output (17) coupled to the output (20) and furthermore coupled to the second input (12) of the subtractor (S1), the quantizer having a specified quantization interval (q1),

**characterized in that** the quantization interval (q1) of the quantizer (Q1) is a prime number.

2. Modulator according to Claim 1, **characterized in that** it further comprises P-1 other Sigma-Delta cells (200, 300), where P is an integer greater than or equal to 2, the P cells (100, 200, 300) being arranged according to a MASH structure, and **in that** the quantization interval of the quantizer of each of the said P cells is equal to the said prime number.

3. Modulator according to Claim 2, **characterized in that** the P-1 other cells (200, 300) have the same structure as the first cell (100).

4. Modulator according to Claim 2 or Claim 3, **characterized in that** the P cells (100, 200, 300) are cells of the first order.

5. Modulator according to any one of Claims 2 to 4, **characterized in that** the respective quantization intervals of the quantizers (Q1, Q2, Q3) of each of the P cells (100, 200, 300), respectively, are equal to each other.

6. Digital frequency synthesizer (Figure 8) comprising a phase-locked loop having a variable frequency divider in the feedback path, **characterized in that** it further comprises a digital to digital $\Sigma$-$\Delta$ modulator (87) according to any one of Claims 1 to 5 in order to encode a signal for controlling the division ratio (Frac(M)) of the said variable frequency divider.

**Patentansprüche**

1. Digital-digitaler Sigma-Delta-Modulator (1), umfassend:

   - einen Eingang (10), um einen digitalen Eingangswert (X) zu empfangen, der in N Bits codiert ist, wobei N eine bestimmte ganze Zahl ist;
   - einen Ausgang (20), um einen digitalen Ausgangswert (Y) zu liefern, der in n Bits codiert ist, wobei n eine bestimmte ganze Zahl kleiner als N ist; und
   - mindestens eine erste Sigma-Delta-Zelle (100), die umfasst:

     - ein Subtrahierglied (S1), umfassend einen ersten Eingang (11), einen zweiten Eingang (12) und einen Ausgang (13), wobei der erste Eingang (11) an den Eingang (10) gekoppelt ist;
     - einen Integrator (11), umfassend einen Eingang (14), der an den Ausgang (13) des Subtrahiergliedes (S1) gekoppelt ist, und einen Ausgang (15); und
     - einen Quantifikator (Q1), umfassend einen Eingang (16), der an den Ausgang (15) des Integrators (I1) gekoppelt ist, und einen Ausgang (17), der an den Ausgang (20) gekoppelt ist und ferner an den zweiten Eingang (12) des Subtrahierglieds (S1) gekoppelt ist, wobei der Quantifikator eine bestimmte Quantifizierungsstufe (q1) aufweist,

   **dadurch gekennzeichnet, dass** die Quantifizierungsstufe (q1) des Quantifikators (Q1) eine Primzahl ist.

2. Modulator nach Anspruch 1, **dadurch gekennzeichnet, dass** er ferner P-1 weitere Sigma-Delta-Zellen (200, 300) umfasst, wobei P eine ganze Zahl größer oder gleich 2 ist, wobei die P Zellen (100, 200, 300) in einer MASH-Struktur angeordnet sind, und dass die Quantifizierungsstufe des Quantifikators jeder der P Zellen gleich der ersten Zahl ist.

3. Modulator nach Anspruch 2, **dadurch gekennzeichnet, dass** die P-1 weiteren Zellen (200, 300) dieselbe Struktur wie die erste Zelle (100) aufweisen.

4. Modulator nach Anspruch 2 oder Anspruch 3, **dadurch gekennzeichnet, dass** die P Zellen (100, 200, 300) Zellen erster Ordnung sind.

5. Modulator nach einem der Ansprüche 2 bis 4, **dadurch gekennzeichnet, dass** die jeweiligen Quantifizierungsstufen der Quantifikatoren (Q1, Q2, Q3) jeder der P Zellen (100, 200, 300) untereinander gleich sind.

6. Digitaler Frequenzsynthesizer (Figur 8), umfassend eine Schleife mit Phasenverriegelung mit einem variablen Frequenzteiler im Retroaktionsweg, **dadurch gekennzeichnet, dass** er ferner einen digital-digitalen Modulator $\Sigma$-$\Delta$ nach einem der Ansprüche 1 bis 5 (87) umfasst, um ein Signal zur Steuerung des Teilungsverhältnisses (Frac(M)) des variablen Frequenzteilers zu codieren.

FIG. 1

FIG. 2

FIG. 5

**FIG. 3a**

q = 6 ; X = 4

Y(t)

3 x Ts

I(t)

6

4

0

**FIG. 3b**

q = 7 ; X = 4

Y(t)

q x Ts

I(t)

7

4

0

**FIG. 3c**

q = 6 ; X = 5

Y(t)

q x Ts

I(t)

6
5

0

**FIG. 3d**

q = 7 ; X = 5

Y(t)

q x Ts

I(t)

7

5

0

FIG. 4a

q = 6 ; X = 4

41

FIG. 4b

q = 7 ; X = 4

41
42
43

FIG. 4c

q = 6 ; X = 5

41
42
43

FIG. 4d

q = 7 ; X = 5

41
42
43

FIG. 6

FIG. 8

FIG. 7a

X = 23168 ; q = 65536

FIG. 7b

X = 23168; q = 65537

FIG. 7c

X = 23167 ; q = 65536

FIG. 7d

X = 23167; q = 65537